Europäisches Patentamt

European Patent Office

Office européen des brevets

(11) Publication number: **0 451 973 A2**

# EUROPEAN PATENT APPLICATION

(21) Application number: 91302405.5

(22) Date of filing: 20.03.91

(51) Int. Cl.⁵: **H03K 19/094, H01L 27/06**

(30) Priority: 29.03.90 JP 79066/90

(43) Date of publication of application:
16.10.91 Bulletin 91/42

(84) Designated Contracting States:
DE FR GB

(71) Applicant: International Business Machines
Corporation
Old Orchard Road
Armonk, N.Y. 10504 (US)

(72) Inventor: **Toshio, Sunaga**
**4-8-4 Wakakusa**
**Kusatsu-shi, Shiga-ken (JP)**

(74) Representative: **Killgren, Neil Arthur**
**IBM United Kingdom Limited Intellectual**
**Property Department Hursley Park**
**Winchester Hampshire SO21 2JN (GB)**

(54) A transistor logical circuit.

(57) A Transistor logical circuit is provided which comprises :
a pair of complementary bipolar transistors connected in series and with their common junction connected to an output terminal,
a pair of complementary input field effect transistors with their gates commonly connected to an input terminal, to complementarily drive said pair of bipolar transistors, and
a pair of complementary discharge field effect transistors connected in parallel between the bases of said pair of bipolar transistors.
This transistor logical circuit operates at high speed and is packageable at high density as an integrated circuit.

EP 0 451 973 A2

FIG. 1

The present invention relates to a transistor logical circuit and more particularly, pertains to a Bipolar Complementary Metal Oxide Semiconductor (BiCMOS) logical circuit which operates at high speed and which is packageable at high density as an integrated circuit.

The BiCMOS logical circuit is drawing attention as a high performance logical circuit, being capable of concurrently achieving the advantage of the low power consumption of complementary MOS (CMOS) field effect transistors (FETS) and the advantage of the high load driving capability of bipolar transistors.

An example of such a BiCMOS logical circuit is disclosed in "Mergel Bipolar CMOS Device," a paper by T. Sunaga, IBM Technical Disclosure Bulletin, Vol. 28, No. 8, Jan., 1986, pp. 3558 - 3561.

The BiCMOS logical circuit disclosed in the paper has a pair of CMOS FETs which respond to an input signal and a pair of complementary bipolar transistors which are driven by the FETs. Each FET, when turned on, feeds a base current to the related bipolar transistor, thereby turning the transistor on, and when turned off, cuts off the base current to the related bipolar transistor, thereby turning the transistor off. However, the logical circuit has no by-pass means for forcibly discharging the charge accumulated in the bases of the bipolar transistors; accordingly, its speed of operation is slow. Also, at the time of switching, both bipolar transistors are rendered conductive, thereby not only increasing power consumption, but causing a deterioration in switching characteristics.

Japanese Published Unexamined Patent Application (PUPA) No. 59-11034 (Hitachi, Ltd.) published on January 20, 1984 discloses a logical circuit in which a pair of input CMOS FETs are connected in series, an output bipolar transistor inverter is composed of an NPN pull-up transistor and a PNP pull-down transistor, and the common junction of the input FETs is commomly connected to the bases of the inverter transistors.

However, commonly connecting the bases of the NPN and PNP transistors of the output inverter produces a problem of slow operation speed. As an example, consider the case where the logical circuit switches from the state of the NPN pull-up being on and the PNP pull-down being off to the state of the NPN being off and the PNP being on.

When the NPN transistor is on, the output voltage, that is, the voltage at the common emitter junction is at a high level (VDD - VBE) (where VDD denotes supply voltage, and VBE base - emitter voltage). Accordingly, the PNP transistor is not rendered conductive, unless the voltage at the common base drops below (VDD - VBE) - VBE = VDD - 2VBE. Similarly, when the PNP transistor is on, the output voltage is VBE; accordingly, the NPN transistor is not rendered conductive, unless the voltage at the common base rises above VBE + VBE = 2VBE. Accordingly, switching does not take place before the voltage at the common base undergoes a change corresponding to 2VBE; therefore, the internal delay is large, thus prohibiting high speed operation. Even if a resistor is inserted between the bases of the NPN and PNP transistors, a similar problem still occurs.

Said PUPA No. 59-11034 further discloses a logical circuit in which both of the pull-up and pull-down transistors are NPN transistors and in which, an N channel FET which responds to an input signal is used as a base charge discharging means. However, when a plurality of input signals are used, there must be provided a number of discharge FETs corresponding to the respective signals, thus involving the problems that the circuit becomes complex, and that a large device area is necessary. Further, when NPN transistors are utilized as the pull-up and pull-down transistors of the output inverter, the pull-up and pull-down transistors need to be isolated from each other. Accordingly, in this instance, three separate N type wells need to be formed for the P channel input FET, the pull-up transistor, and the pull-down transistor, resulting in a large device area. Although the NPN transistor is operable at higher speed than the PNP transistor, the switching speed is not much improved, because of the junction capacitance of the N type well which constitutes the collector of the pull-down transistor.

An object of the present invention is to provide a transistor logical circuit which can operate at high speed while permitting high density integration.

Viewed from a first aspect the present invention provides a transistor logical circuit comprising:

a pair of complementary bipolar transistors connected in series and with their common junction connected to an output terminal,

a pair of complementary input field effect transistors with their gates commonly connected to an input terminal, to complementarily drive said pair of bipolar transistors, and

a pair of complementary discharge field effect transistors connected in parallel between the bases of said pair of bipolar transistors.

In preferred embodiments the pair of complementary input field effect transistors receive an input signal and the pair of complementary bipolar transistors are complementarily driven by the input field effect transistors. Conveniently the discharge field effect transistors are diode-connected, thereby providing discharging paths for the accumulated charge in the bases of the bipolar transistors.

In preferred embodiments the pull-up transistor of the pair of bipolar transistors is an NPN transistor and the pull-down transistor is a PNP transistor. Conveniently the PNP transistor and the N channel field effect transistors are formed in a P type substrate, while the NPN transistor and the P channel field effect transistors are formed in an N type well provided in the P type substrate; this facilitates high density integration. To further increase the density of packaging both of the bipolar transistors can be formed as vertical transistors, with their bases serving as the source/drain regions of the associated discharge field effect transistors. This embodiment of the invention enables a high performance BiCMOS logical circuit to be formed at high density, using only one well region, without making use of any special isolation means.

The present invention will be described further, by way of example only, with reference to an embodiment thereof as illustrated in the accompanying drawings, in which:

Figure 1 shows a preferred embodiment of the present invention in which the transistor logical circuit is a BiCMOS logical circuit; and

Figure 2 is a schematic diagram showing an integrated circuit structure for the logical circuit of Figure 1.

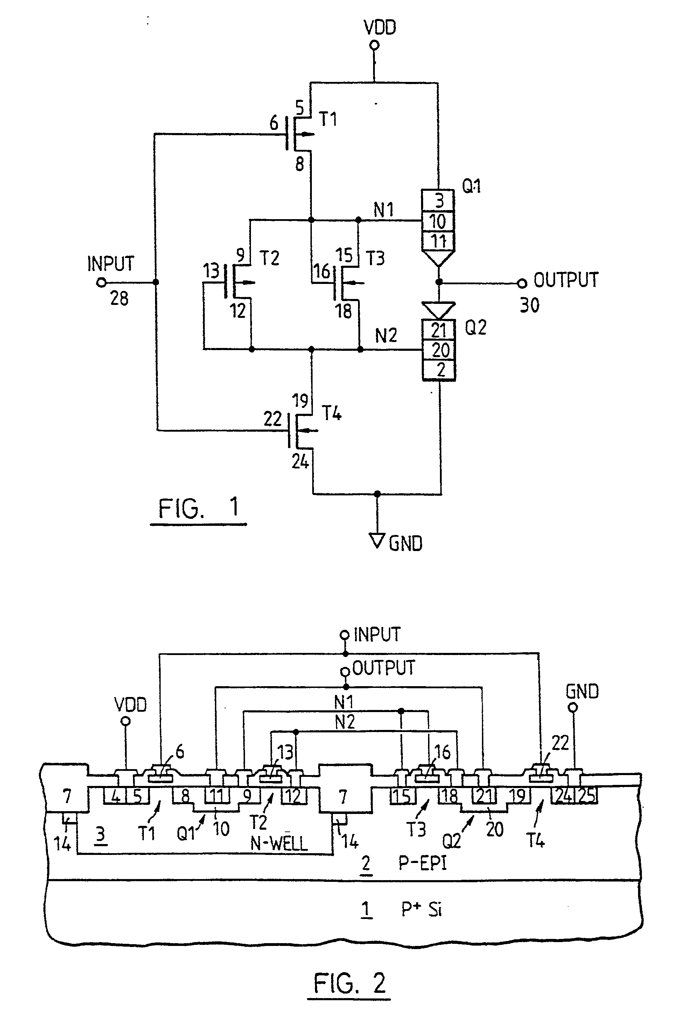

Figure 1 shows the BiCMOS logical circuit. This logical circuit has a pair of input CMOS FETs T1 and T4 and a pair of output bipolar transistors Q1 and Q2. FET T1 is a P channel transistor; FET T4 is an N channel transistor; the transistor Q1 is an NPN transistor; and the transistor Q2 is a PNP transistor. The source 5 of FET T1 is connected to a supply voltage VDD, its gate 6 to an input terminal 28, and its drain 8 to the base 10 of the NPN transistor Q1. The drain 19 of FET T4 is connected to the base 20 of the PNP transistor Q2, its gate 22 to the input terminal 28, and its source to a reference voltage set to ground voltage (GND). The collector 3 of the transistor Q1 is connected to the supply voltage VDD, and its emitter 11 to an output terminal 30. The emitter 21 of the transistor Q2 is connected to the output terminal 30, and its collector 2 to the reference voltage GND.

Between the bases 10, 20 of the transistors Q1 and Q2, a pair of diode-connected CMOS FETs T2 and T3 are connected. FET T2 is a P channel transistor and FET T3 is an N channel transistor, The source 9 of FET T2 is connected to the base 10 of the transistor Q1, and its gate 13 and drain 12 are commonly connected to the base 20 of the transistor Q2. The drain 15 and gate 16 of FET T3 are commonly connected to the base 10 of the transistor Q1, and its source 18 is connected to the base 20 of the transistor Q2.

Figure 2 is a schematic diagram showing the integrated circuit structure for the BiCMOS logical circuit of Figure 1. Corresponding elements given in Figures 1 and 2 are noted by the identical reference numerals. The PNP transistor Q2 and the N channel FETs T3 and T4 are formed in a P $^-$ epitaxial layer 2. formed on a P $^+$ silicon substrate 1. The NPN transistor Q1 and the P channel FETs T1 and T2 are formed in an N $^-$ well 3 provided in the epitaxial layer 2.

The P channel FET T1 is formed by a P $^+$ source region 5, a P $^+$ drain region 8 and a polysilicon gate 6. The P channel FET T2 is formed by a P $^+$ source region 9, a P $^+$ drain region 12 and a polysilicon gate 13. The NPN transistor Q1 is formed by an N $^+$ emitter region 11, a P $^-$ base region 10 and the N $^-$ well 3 which serves as a collector region. The N channel FET T3 is formed by an N $^+$ drain region 15, an N $^+$ source region 18 and a polysilicon gate 16. The N channel FET T4 is formed by an N $^+$ drain region 19, an N $^+$ source region 24 and a polysilicon gate 22. The PNP transistor Q2 is formed by a P $^+$ emitter region 21, an N $^-$ base region 20 and the epitaxial layer 2 which serves as a collector region. Region 4 is an N $^+$ well contact provided adjacent to the source region 5 of T1 and region 25 is a P $^+$ substrate contact provided adjacent to the source region 24 of T4. Region 7 is a field oxide region and region 14 is a P $^+$ field stop region.

Transistors Q1 and Q2 are formed as vertical transistors. The drain region 8 of FET T1 and the source region 9 of FET T2 constitute extrinsic base regions of the transistor Q1, and the source region 18 of FET T3 and the drain region 19 of FET T4 constitute extrinsic base regions of the transistor Q2.

The structure of Figure 2 can be readily manufactured by well-known CMOS processes. The only difference is that two ion implantation steps are added to form the intrinsic base regions 10 and 20 of the transistors Q1 and Q2. Since the manufacturing process is considered obvious, detailed description is omitted.

In the following, the operation of the logical circuit of this invention is described. When the input signal is at a low level, FET T1 is on and FET T4 is off. As T1 is turned on, a base current is fed to the transistor Q1, thereby turning transistor Q1 on. Then at output terminal 30, a high voltage level of VDD - VBE is generated. Transistor Q2 is off. At this time, the voltage at node N1 is VDD and the potential difference between nodes N1 and N2 is clamped at the threshold voltage VTP of FET T2. Specifically assuming the threshold voltage of FET T3 to be VTN, the state of VTN>VTP is held, because of the substrate bias effect, when the voltage at node N1 = VDD; therefore, the voltage at node N2 is VDD - VTP.

When the input changes from the low level to a high level under this state, T4 is turned on and T1 is turned off; as a result, the voltage at node N2 drops. Initially T2 is highly conductive and, therefore, the base charge of the transistor Q1 is withdrawn mainly through T2. As the voltage at node N2 further drops, the substrate bias effect of T3 decreases; on the other hand, the substrate bias effect of T2 increases, resulting in VTN<VTP. Then the base charge is withdrawn strongly through T3. The withdrawn base charge is discharged to GND through T4. As the voltage at node N2 is finally reduced to GND, node N1 is clamped at VTN, and T2 is nearly in an off state.

Conversely, when the input changes from high to low, initially T3 and, then, T2 form the main discharge path for the base charge of the transistor Q2, so that the base charge is discharged to VDD through T1.

Accordingly, in the circuit of the preferred embodiment, whichever the case may be, a discharge path for efficiently withdrawing the base charge is formed, thereby enabling a high speed switching operation to be achieved. Also, the above-described node voltage clamping action further increases the speed of operation. Now assuming that T1 is on and that the voltage at node N1 is VDD = 5V, the output voltage (VDD - VBE) is approx. 4.4V and the voltage at node N2 (VDD - VTP) is approx. 4V. Then as T4 is turned on, Q2 is rendered conductive when the voltage at node N2 is 4.4 - VBE, ie. approx. 3.8V. That is to say, Q2 switches in response to a change in the voltage at node N2 of only approx. 0.2V (from approx. 4V to approx. 3.8V) thus ensuring a small internal delay and thus high speed. In contrast, if a resistor is substituted for T2 and T3, the voltage at nodes N1 and N2 before T4 is on is VDD = 5V; therefore, Q2 is not turned on, unless the voltage at node N2 changes by 5V - 3.8V = 1.2V.

Characteristic features of the logical circuit of the described preferred embodiment are listed hereunder:

(1) High speed switching is achieved through the rapid base charge discharging action and node voltage clamping action of the P channel FET T2 and N channel FET T3 which are diode-connected.

(2) The circuit may be readily altered to a multi-input logical circuit by adding one or more P channel FETs connected in parallel with the P channel FET T1 and one or more N channel FETs connected in series with the N channel FET T4, and by applying individual input signals to the respective P-N FET pairs. Even in this multi-input case, only one pair of base discharge PMOS T2 and NMOS T3 transistors is required.

(3) The NPN transistor Q1 and PNP transistor Q2 both operate as emitter followers, with each base-collector junction not forward-biased, thus permitting Q1 and Q2 to operate at high speed under unsaturation mode.

(4) A PNP transistor is used as the pull-down; accordingly, there is no problem of speed-down due to the well-substrate junction capacitance which occurs when an NPN transistor is used as the pull-down transistor and is formed in a separate well. Besides, the PNP transistor may be formed as a vertical transistor having a thin base layer, thus enabling realization of a high performance PNP.

(5) The collector of the NPN pull-up transistor is fixed to VDD, and the collector of the PNP pull-down transistor is fixed to GND. Accordingly, the N well - substrate capacitance does not affect the speed of operation.

(6) Only one N well is required. FETs T2 and T3 which conduct small current may be small in size and, moreover, they share the device regions with Q1 and Q2. Therefore, high integration density can be achieved.

**Claims**

1. A transistor logical circuit comprising:
   a pair of complementary bipolar transistors connected in series and with their common junction connected to an output terminal,
   a pair of complementary input field effect transistors with their gates commonly connected to an input terminal, to complementarily drive said pair of bipolar transistors, and
   a pair of complementary discharge field effect transistors connected in parallel between the bases of said pair of bipolar transistors.

2. A transistor logical circuit as claimed in Claim 1 wherein:
   said pair of bipolar transistors comprises a first bipolar transistor connected between a supply terminal and an output terminnal, and a second bipolar transistor complementary to said first bipolar transistor and connected between said output terminal and a reference terminal; and
   said pair of input field effect transistors comprises a first field effect transistor connected between said supply terminal and the base of said first bipolar transistor and with its gate connected to an input terminal, and a second field effect transistor complementary to said first field effect transistor and connected between the base of said second bipolar transistor and said reference terminal and with its gate connected to said input terminal.

3. A transistor logical circuit as claimed in Claim 2, wherein said first field effect transistor is a P channel field effect transistor and said second field effect transistor is an N channel field effect transistor, and wherein said first bipolar transistor is an NPN transistor and said second bipolar transistor is a PNP transistor.

4. A transistor logic circuit as claimed in any preceding claim, wherein said discharge field effect transistors are diode-connected.

5. A transistor logical circuit as claimed in claim 3 wherein:
   said NPN transistor has its collector connected to said supply terminal, and its emitter to said output terminal;
   said PNP transistor has its emitter connected to said output terminal, and its collector to said reference terminal;

said P channel field effect transistor has its source connected to said supply terminal, its drain to the base of said NPN transistor, and its gate to said input terminal;

said N channel field effect transistor has its drain connected to the base of said PNP transistor, its source to said reference terminal, and its gate to said input terminal; and

said pair of discharge field effect transistors comprises a P channel discharge field effect transistor with its source connected to the base of said NPN transistor, and its drain and gate commonly connected to the base of said PNP transistor, and a N channel discharge field effect transistor with its drain and gate commonly connected to the base of said NPN transistor, and its source to the base of said PNP transistor.

6. A transistor logical circuit as claimed in claim 5, wherein:

said N channel field effect transistor, said N channel discharge field effect transistor and said PNP transistor are formed in a P type substrate, and

said P channel field effect transistor, said P channel discharge field effect transistor and said NPN transistor are formed in an N well region provided in said substrate,

7. A transistor logical circuit as claimed in claim 6, wherein said NPN and PNP transistors are formed perpendicular to the surface of said P-type substrate.

FIG. 1

FIG. 2